# EUROPEAN PATENT SPECIFICATION

(11) **EP 0 637 639 B1**
(45) Date of publication and mention of the grant of the patent: **15.10.1997**
(21) Application number: 94305834.7
(22) Date of filing: 05.08.1994
(51) Int. Cl.: C23C 16/26

(54) **A process for the synthesis of diamond**
Verfahren zur Synthese von Diamanten
Procédé pour la synthèse de diamants

(30) Priority: 06.08.1993 JP 196035/93
(43) Date of publication of application: 08.02.1995
(73) Proprietor: SUMITOMO ELECTRIC INDUSTRIES, LIMITED, Osaka 541 (JP)
(72) Inventor: Ota, Nobuhiro, c/o Itami Works, Itami-shi, Hyogo (JP); Fujimori, Naoji, c/o Itami Works, Itami-shi, Hyogo (JP)
(74) Representative: Allard, Susan Joyce

(56) References cited:
- EP-A- 0 411 424
- EP-A- 0 452 051
- EP-A- 0 534 729
- DE-A- 3 522 583
- FR-A- 2 635 535

## Description

This invention relates to a process for the synthesis of diamond by a hot-filament assisted CVD method and, more particularly, it is concerned with a process for the synthesis of diamond whereby high quality diamond can be produced at high speed with a low electric power consumption and, therefore, at a low cost.

Since the study of the hot-filament assisted CVD method by Matsumoto in 1982 (Jpn. J. Appl. Phys.; 21 1982 L183), the technique for the synthesis of diamond has actively been developed and various procedures have been studied. Above all, a hot-filament assisted CVD method comprising applying an electric current to heat a metallic filament or a filament consisting of a carburized metallic element and using the filament as an excitation source has the advantages that the procedure thereof is very simple and enlargement of the area can be carried out in a relatively simple manner.

In the hot-filament assisted CVD method, a metallic filament of tungsten, etc. is heated by applying an electric current thereto, a raw material gas containing carbon is excited and cracked and diamond is deposited in a non-equilibrium state onto a substrate heated at a temperature of approximately 800°C and at a pressure of at most 10⁵ Pa (1 atm).

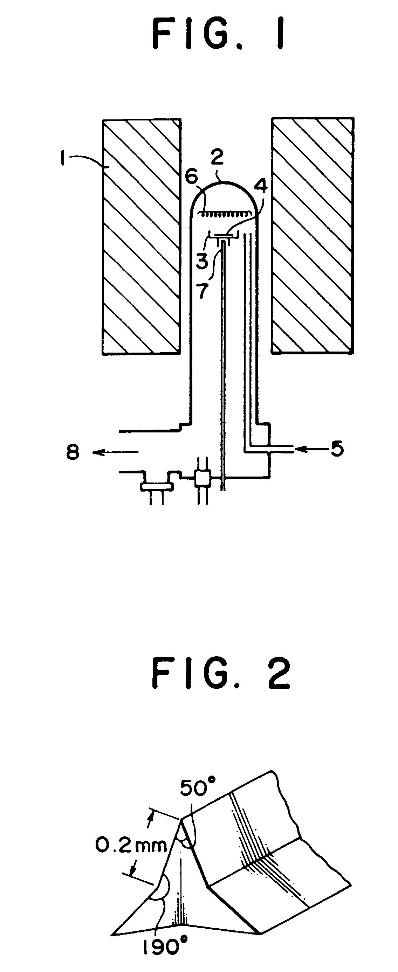

Fig. 1 is a schematic view showing an example of the hot-filament assisted CVD method. In this example, a substrate 4 is placed on a substrate supporting base 3 made of silica in a reactor 2 made of silica provided in a furnace 1. A feed gas 5 containing carbon is fed into the reactor while evacuating by means of a pump 8 (not shown) and heated and excited by a tungsten filament 6 in order to deposit diamond onto the substrate 4. In Fig. 1, 7 corresponds to a thermocouple for measuring the temperature.

Up to the present time, filaments used for this method are either coiled filaments each having a circular cross-section ("NEW DIAMOND" Vol. 6, No. 1, 9-15), or filaments having a plurality of linear filaments each having a circular cross section, arranged under tension in parallel (Japanese Patent Laid-Open Publication No. 115576/1991); little consideration, however, has been given to the shape of the filament itself.

With regard to the gaseous phase synthesis of diamonds, a number of reports have indicated that atomic hydrogen is associated with the formation of diamond and the diamond formation mechanism related therewith has been reported in a number of papers (e.g. "Appl. Phys. Lett." 56 (23) 2298-2300). According to these reports, when diamond is synthesized in the gaseous phase, it is important that a large amount of atomic hydrogen is produced.

In the gaseous phase synthesis of diamonds, it has hitherto been considered necessary, for the formation of a film at a high speed, to apply a high electric power and maintain a high gas temperature ("DIAMOND AND RELATED MATERIALS", Vol.1 (1991), pp 1-12).

In the hot-filament assisted CVD method, it is similarly considered effective to increase the amount of atomic hydrogen generated, so as to increase the growth speed of diamond and improve the film quality of the diamond. To this end, raising the filament temperature and increasing the filament diameter in order to increase the electric power that can be applied, have been examined (e.g. "Funtai oyobi Funmatsu Yakin (Powder and Powder Metallurgy)" Vol. 34, No. 9, 395-401; "J. Appl. Phys." 71(3) 14851493; "APPLIED OPTICAS" Vol. 29, No. 33, 4993-4999).

For the production of diamond on a commercial scale, however, a decrease in electric power consumption is desirable, since power costs add considably to production costs. In addition, if a large quantity is generated in the vacuum container, a large number of devices are necessary in order to cool the substrate supporting base, inner wall of the container, etc. (Japanese Patent Laid-Open Publication No. 115576/1991).

It is considered that a substrate temperature range suitable for the growth of diamond is in the range of from approximately 800 °C to 1000 °C. The substrate is sandwiched in between an excitation source at a very high temperature and a high efficiency coolant and is, therefore, subjected to very high thermal strains, resulting in the undesirable occurence of cracks in the sample and warping of the substrate.

We have now developed an improved process for the synthesis of diamond by a hot-filament assisted CVD method, enabling the synthesis of high quality diamond at high speed with a low electric power consumption and low production cost.

Accordingly, the present invention provides a process for the gaseous phase synthesis of diamond by a hot-filament CVD method using a heating body consisting of a metal or metal carbide as an excitation source, characterized in that the heating body has a larger specific surface area (surface area/volume) than a filament with a circular cross-section for the same cross-sectional area.

The accompanying drawings are to illustrate the principle and merits of the present invention in greater detail.

Fig. 1 is a schematic view of an apparatus for the synthesis of diamond by a hot-filament assisted CVD method.

Fig. 2 is a schematic view of the cross-section of a heating body used in Example 4.

From an analysis of the gaseous reaction in the gaseous phase synthesis of diamond by the hot-filament assisted CVD method, in particular, the mechanism for producing atomic hydrogen, we have found that the atomic hydrogen is produced in a proportion of about 100 % by a heterogeneous catalytic reaction on the surface of the filaments and the reaction rate constant of the dissociation-association reaction between hydrogen molecules/atomic hydrogen thereon is approximately several tens times as large as that in the ordinary gaseous phase.

Based on this knowledge, we have made further studies on the shape of the filament and, consequently, have succeeded in producing a large quantity of atomic hydrogen by a low energy method, by enlarging the specific area of the filament as compared to a circular cross-section filament having the same cross-sectional area (i.e. same volume), thereby increasing the growth rate of diamond, whilst consuming the same amount of electric power as would be consumed by the ciruclar cross-section filament.

Accordingly, the present invention provides (1) a process for the gaseous phase synthesis of diamond by a hot-filament assisted CVD method using a heating body consisting of a metal or metal carbide as an excitation source, characterized in that the heating body has a larger specific surface area (surface area/volume) than a filament with a circular cross-section for the same cross-sectional area, and (2) a process for the gaseous phase synthesis of diamond by a hot-filament assisted CVD method using a heating body consisting of a metal or metal carbide as an excitation source, characterized in that the heating body, which is used as an excitation source, is composed of a bundle of two or more linear heating bodies; two or more linear heating bodies twisted around each other; a linear heating body having a deformed cross-section; or a plate-shaped heating body.

Suitable metals for use in the process of the present invention include tungsten, tantalum, rhenium or alloys thereof, and suitable metal carbides for use in the process of the present invention include tungsten carbide (WC, W₂C), tantalum carbide (TaC) and mixtures or solid solutions thereof. In particular, rhenium is resistant to carburization and is capable of ensuring a longer service life. In addition, the metal carbide includes a metallic element partially or wholly carburized from the metallic element before or during the diamond synthesis reaction. When using a heating body consisting of a metal for an increased time, the whole heating body is converted into its carbide, e.g. WC, W₂C, TaC, etc.

As preferred embodiments of the present invention, there are provided processes as described above in (2), wherein the linear heating body has a diameter in the range of from 0.02 to 2 mm, the linear heating body has a deformed cross-section, the plate-shaped heating body has a thickness in the range of from 10 to 1000 µm or the plate-shaped heating body consists of a porous material, and processes as described above in (1) or (2), wherein the specific surface area (surface area/volume) of the heating body is in the range of from 2 mm⁻¹ to 210 mm⁻¹ on a calculated basis.

The most important feature of the process according to the present invention consists in that the specific surface area (surface area/volume) of the heating body, as an excitation source, is rendered larger than when using an ordinary filament having a circular cross-section and having the same cross-sectional area as the heating body in the present invention.

Specific means for enlarging the specific surface area comprise, individually or in combination: (i) bundling or twisting a plurality of filaments; (ii) forming the cross-sectional shape into a deformed shape (non-circular shape), e.g. triangular or polygonal shape having a convex angle inside, similar to a star shape; (iii) forming into plate shapes such as thin sheets or foils; and (iv) using a porous body such as foamed metals. As the material of the porous body, tungsten, tantalum, rhenium, WC, TaW and the like may be used.

The specific area is preferably in the range of from 2 mm⁻¹ to 210 mm⁻¹ on a calculated basis ("calculated basis" - a value, which is used as an index for the shape of a filament, obtained by calculating the volume and surface area of a filament by approximating the outside of the filament to a relatively simple straight line or curved line). With regard to the surface area, it has hitherto been known that fine scratches or cracks occur on the surface of a filament during its production and that a filament tends to be subjected to carburization and fine cracks are formed during gaseous synthesis of diamond (e.g. "NEW DIAMOND" Vol. 6, No. 1, 9-15). Naturally, the real surface area of the filament is increased by these phenomena independently of the shape of the filament, but the increment in the surface area due to such scratches or cracks is not included in the determination of the specific surface area by the aforementioned calculated basis.

The heating body used as an excitation source in a hot-filament assisted CVD method is heated by the passage of an electric current. In the present invention, it is found that one site where atomic hydrogen is generated is on the surface of the heating body and based upon this finding, the surface area is increased, whilst simultaneously the cross-sectional area, i.e. volume of a filament is decreased so as to suppress energy required for heating to minimum, namely the specific area is increased.

In the gaseous phase synthesis of diamond, the surface area and surface temperature of a heating body, as an excitation source, are important. The surface temperature is preferably rendered higher as far as it is possible, being limited by the physical properties of the heating body. To reach this surface temperature, heating by the passage of an electric current is ordinarily carried out, but when the specific surface area (surface area/volume) is less than approximately 2 mm⁻¹, more energy is consumed for raising the temperature of the whole body of the excitation source to the detriment of effective atomic hydrogen generation. On the other hand, it is naturally apparent that a large specific surface area is more effective, but when the specific surface area (surface area/volume) is more than approximately 210 mm ⁻¹, various problems tend to arise in the mechanical and physical stability of the heating body exposed to a high temperature. This is not preferable.

A method for bringing the specific surface area into a suitable range comprises bundling or twisting a plurality of linear heating bodies, whereby a large amount of atomic hydrogen can effectively be generated in a limited space. For example, the electric power required when a heating body consisting of ten filaments each having a diameter of 0.3 mm is heated to produce atomic hydrogen is approximately 40 % of the electric power required when one filament having a circular cross-section with a diameter of 3 mm is heated to produce the same amount of atomic hydrogen. In this case, the amount of atomic hydrogen produced is measured by a laser induced fluorescence spectroscopic method. Furthermore, it is confirmed that in the case of a heating body consisting of twenty-six filaments each having a diameter of 0.3 mm, atomic hydrogen in an amount of at least two times as much as in the case of one filament having a diameter of 3 mm, can be produced for the same electric power. When the growth speeds of diamond are compared under these conditions, the growth speeds of diamond are substantially the same in the former example and at least two times different in the latter example.

In addition, of course, atomic hydrogen can be produced on a larger area and diamond can thus be formed on a larger area by arranging in parallel or knitting in a mesh a plurality of heating bodies each consisting of an assembly of filaments. Similarly, it is confirmed that a method comprising forming the cross-sectional shape into a deformed shape, e.g. triangular or polygonal shape having a convex angle inside or a method comprising combining them is effective for increasing the speed of diamond synthesis.

The following examples are given in order to illustrate the present invention in detail without limiting the same.

### Examples 1 to 7 and Comparative Examples 1 to 2

Synthesis tests of diamond were carried out by placing a substrate (10 mm square) for the synthesis of diamond in an ordinary vacuum vessel, using various heating bodies (made of tungsten) of 100 mm in length shown in Table 1 as excitation sources and using a mixed gas of 99 % hydrogen and 1 % methane, as a raw material gas. The synthesis conditions are shown below:

The heating body, as an excitation source, was heated by passing AC in such a manner that when carburization of the heating body was finished, the surface temperature of the heating body be 2050°C, while feeding the raw material gas at a pressure of 40 Torr. When using the heating body of tungsten, there were formed WC + W₂C on the surface thereof, and when using tantalum, there was formed TaC.

At that time, the amount of atomic hydrogen was measured by a laser-induced fluorescence spectroscopic method. The measured results were shown by the output voltage (volt), as shown by the amount of atomic hydrogen in Table 1, obtained by detecting and amplifying the fluorescence intensity from atomic hydrogen using a photomultiplier and boxcar. The larger the output value, the larger proportionally the concentration of atomic hydrogen. The measured values were not absolute values; however, relative changes due to difference of the excitation sources were correctly measured since the measurements were carried out under the same conditions in all Examples and Comparative Examples.

Diamond was then synthesized by maintaining the distance of substrate-excitation source at 5 mm (10 mm in Comparative Example 2) and the substrate temperature at 900 °C and the growth rate of diamond phase was measured. The film quality of the resulting diamond was assessed by a Raman spectroscopic method to define the resulting samples, having less non-diamond components such as amorphous carbon and a strong intensity of diamond (amorphous carbon/diamond peak ratio: at most 0.1), as "good".

The results are tabulated in Table 1:

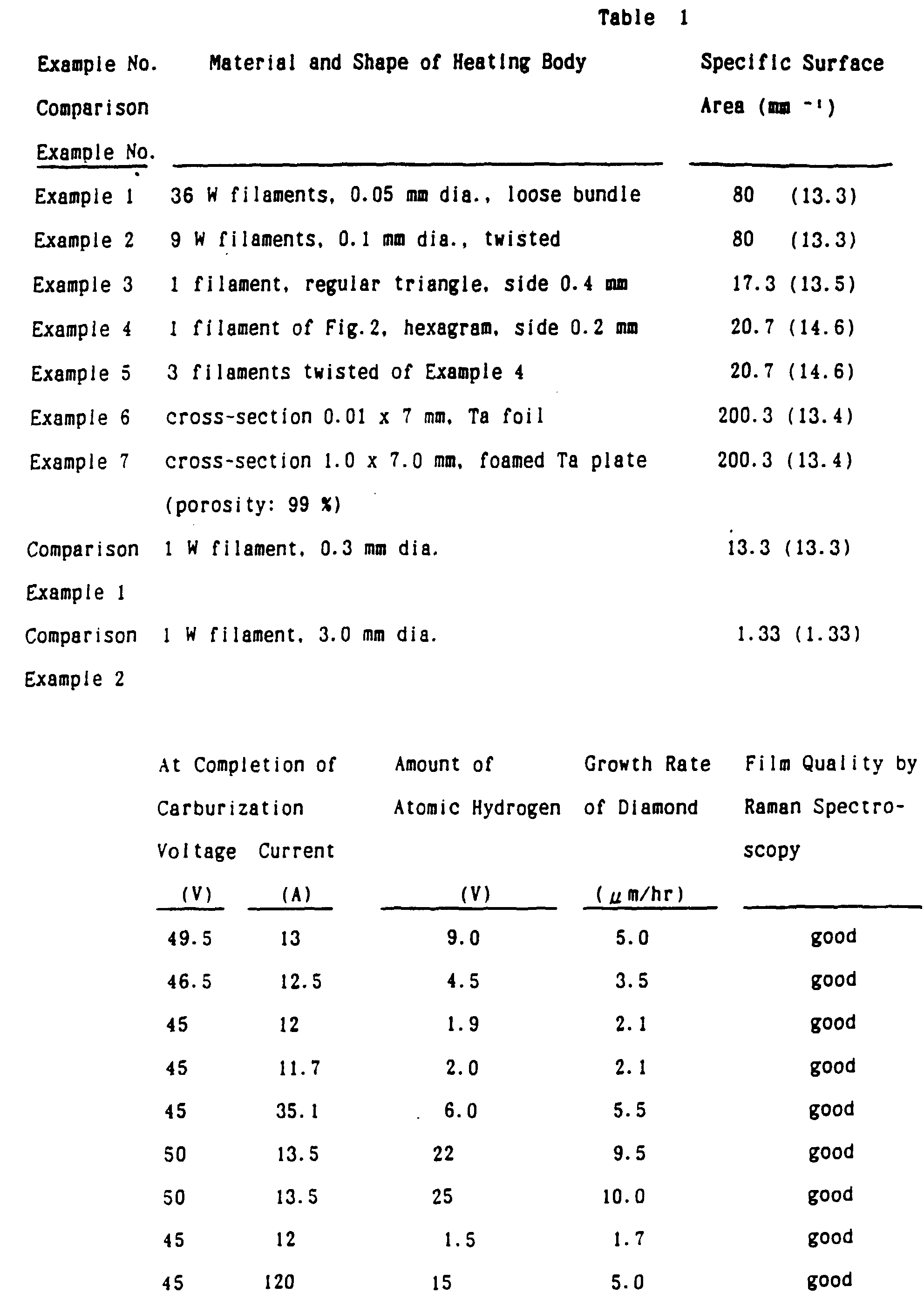

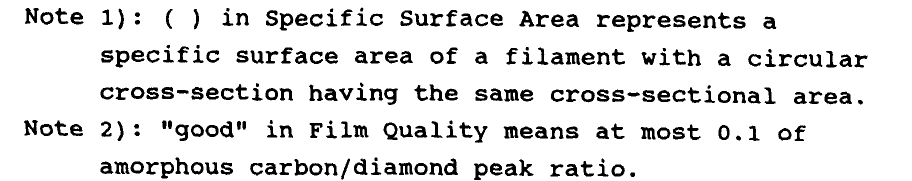

It will clearly be understood from the results of Table 1 that in the process of the present invention as shown in Examples 1 to 7, the amount of atomic hydrogen produced is larger, the growth speed of diamond is higher and diamond with good film quality can be obtained in a shorter time, for the electric power consumed.

In Comparative Example 1, one tungsten filament having the same cross-sectional area as in Example 2 was used, but the electric power applied was 93 % of that of Example 2 and the growth speed of diamond was at most half thereof.

In Comparative Example 2, one tungsten filament having the same cross-sectional area as in Example 1 was used, but the distance between the substrate and excitation source was 10 mm corresponding to a distance capable of cooling the substrate. In this example, the growth speed of diamond was substantially the same as in Example 1, but the electric power applied was 8.4 times as much as that of Example 1.

According to the present invention, an increase in the gaseous phase synthesis rate of diamond can be realized with a lower energy and lower electric power consumption as compared to the hot-filament assisted CVD method of the prior art. Without raising the temperature of the excitation source to higher than required, the growth rate of diamond can be increased and thermal strain in a sample can be suppressed to a greater extent, whereby good quality diamond is obtained.

## Claims

1. A process for the gaseous phase synthesis of diamond by a hot-filament CVD method using a heating body consisting of a metal or metal carbide as an excitation source, characterized in that the heating body has a larger specific surface area (surface area/volume) than a filament with a circular cross-section for the same cross-sectional area.

2. A process for the gaseous phase synthesis of diamond as claimed in Claim 1, wherein the metal is tungsten, tantalum, rhenium or an alloy thereof.

3. A process for the gaseous phase synthesis of diamond as claimed in Claim 1, wherein the metal carbide is tungsten carbide, tantalum carbide or a mixture thereof.

4. A process for the gaseous phase synthesis of diamond as claimed in any one of Claims 1 to 3, wherein the heating body is composed of a bundle of at least two linear heating bodies, or at least two linear heating bodies twisted around each other.

5. A process for the gaseous phase synthesis of diamond as claimed in Claim 4, wherein the linear heating body has a diameter in the range of from 0.02 to 2 mm.

6. A process for the gaseous phase synthesis of diamond as claimed in any one of Claims 1 to 5, wherein the heating body is a linear heating body having a deformed cross-sectional shape.

7. A process for the gaseous phase synthesis of diamond as claimed in any one of Claims 1 to 3, wherein the heating body is a plate-shaped heating body.

8. A process for the gaseous phase synthesis of diamond as claimed in Claim 7, wherein the plate-shaped heating body has a thickness in the range of from 10 to 1000 µm.

9. A process for the gaseous phase synthesis of diamond as claimed in Claim 7 or Claim 8, wherein the plate-shaped heating body consists of a porous material.

10. A process for the gaseous phase synthesis of diamond as claimed in Claim 9, wherein the porous material is tungsten, tantalum, rhenium, tungsten carbide or TaW.

11. A process for the gaseous phase synthesis of diamond as claimed in any one of the Claims 1 to 9, wherein the specific surface area (surface area/volume) of the heating body on a calculated basis is in the range of from 2 mm⁻¹ to 210 mm⁻¹.

## Patentansprüche

1. Verfahren zur Gasphasensynthese von Diamant mittels eines Heißfilament CVD-Verfahrens unter Verwendung eines aus einem Metall oder einem Metallcarbid bestehenden Heizkörpers als Anregungsquelle, dadurch gekennzeichnet, daß der Heizkörper einen größeren spezifischen Oberflächenbereich (Oberflächenbereich/Volumen) aufweist, als ein Filament mit einem ringförmigen Querschnitt für den gleichen Querschnittsbereich.

2. Verfahren zur Gasphasensynthese von Diamant nach Anspruch 1, bei dem das Metall Wolfram, Tantal, Rhenium oder eine Legierung davon ist.

3. Verfahren zur Gasphasensynthese von Diamant nach Anspruch 1, bei dem das Metallcarbid Wolframcarbid, Tantalcarbid oder ein Gemisch davon ist.

4. Verfahren zur Gasphasensynthese von Diamant nach einem der Ansprüche 1 bis 3, bei dem der Heizkörper aus einem Bündel von mindestens 2 linearen Heizkörpern, oder aus mindestens 2 linearen, umeinander gewundenen Heizkörpern besteht.

5. Verfahren zur Gasphasensynthese von Diamant nach Anspruch 4, bei dem der lineare Heizkörper einen Durchmesser im Bereich von 0,02 bis 2 mm aufweist.

6. Verfahren zur Gasphasensynthese von Diamant nach einem der Ansprüche 1 bis 5, bei dem der Heizkörper ein linearer Heizkörper mit einer verformten Querschnittsform ist.

7. Verfahren zur Gasphasensynthese von Diamant nach einem der Ansprüche 1 bis 3, bei dem der Heizkörper ein plattenförmiger Heizkörper ist.

8. Verfahren zur Gasphasensynthese von Diamant nach Anspruch 7, bei dem der plattenförmige Heizkörper eine Dicke im Bereich von 10 bis 1000 µm aufweist.

9. Verfahren zur Gasphasensynthese von Diamant nach Anspruch 7 oder Anspruch 8, bei dem der plattenförmige Heizkörper aus einem porösen Material besteht.

10. Verfahren zur Gasphasensynthese von Diamant nach Anspruch 9, bei dem das poröse Material Wolfram, Tantal, Rhenium, Wolframcarbid oder TaW ist.

11. Verfahren zur Gasphasensynthese von Diamant nach einem der Ansprüche 1 bis 9, bei dem der spezifische Oberflächenbereich (Oberflächenbereich/ Volumen) des Heizkörpers gemäß Berechnung im Bereich von 2 mm⁻¹ bis 210 mm⁻¹ liegt.

## Revendications

1. Procédé pour la synthèse en phase gazeuse de diamant par un procédé CVD à filament chaud utilisant un corps de chauffage consistant en un métal ou un carbure de métal comme source d'excitation, caractérisé en ce que le corps de chauffage a une plus grande surface spécifique (surface/volume) qu'un filament avec une section transversale circulaire pour la même superficie de section.

2. Procédé pour la synthèse en phase gazeuse de diamant selon la revendication 1, dans lequel le métal est du tungstène, du tantale, du rhénium ou un alliage de ceux-ci.

3. Procédé pour la synthèse en phase gazeuse de diamant selon la revendication 1, dans lequel le carbure de métal est du carbure de tungstène, du carbure de tantale ou un mélange de ceux-ci.

4. Procédé pour la synthèse en phase gazeuse de diamant selon l'une quelconque des revendications 1 à 3, dans lequel le corps de chauffage est composé d'un faisceau d'au moins deux corps de chauffage linéaires, ou d'au moins deux corps de chauffage linéaires enroulés l'un autour de l'autre.

5. Procédé pour la synthèse en phase gazeuse de diamant selon la revendication 4, dans lequel le corps de chauffage linéaire a un diamètre dans la plage de 0,02 à 2 mm.

6. Procédé pour la synthèse en phase gazeuse de diamant selon l'une quelconque des revendications 1 à 5, dans lequel le corps de chauffage est un corps de chauffage linéaire ayant une section transversale déformée.

7. Procédé pour la synthèse en phase gazeuse de diamant selon l'une quelconque des revendications 1 à 3, dans lequel le corps de chauffage est un corps de chauffage en forme de plaque.

8. Procédé pour la synthèse en phase gazeuse de diamant selon la revendication 7, dans lequel le corps de chauffage en forme de plaque a une épaisseur dans la plage de 10 à 1000 µm.

9. Procédé pour la synthèse en phase gazeuse de diamant selon la revendication 7 ou la revendication 8, dans lequel le corps de chauffage en forme de plaque consiste en un matériau poreux.

10. Procédé pour la synthèse en phase gazeuse de diamant selon la revendication 9, dans lequel le matériau poreux est du tungstène, du tantale, du rhénium, du carbure de tungstène, ou du TaW.

11. Procédé pour la synthèse en phase gazeuse de diamant selon l'une quelconque des revendications 1 à 9, dans lequel la surface spécifique (surface/volume) du corps de chauffage sur une base calculée est dans la plage de 2 mm⁻¹ à 210 mm⁻¹.
